Europäisches Patentamt

European Patent Office

Office européen des brevets

(19)

(11) Veröffentlichungsnummer: **0 029 538**
**B1**

(12) **EUROPÄISCHE PATENTSCHRIFT**

(45) Veröffentlichungstag der Patentschrift:
**10.04.85**

(21) Anmeldenummer: **80106879.2**

(22) Anmeldetag: **07.11.80**

(51) Int. Cl.⁴: **H 01 L 27/08**, H 03 F 1/32

(54) **Integrierbare Schaltung zur Verhinderung des Sättigungszustandes eines Transistors.**

(30) Priorität: **26.11.79 DE 2947599**

(43) Veröffentlichungstag der Anmeldung:
**03.06.81 Patentblatt 81/22**

(45) Bekanntmachung des Hinweises auf die Patenterteilung:
**10.04.85 Patentblatt 85/15**

(84) Benannte Vertragsstaaten:
**FR GB IT**

(56) Entgegenhaltungen:
**CH - A - 455 878**
**FR - A - 2 297 522**
**GB - A - 2 008 317**
**US - A - 3 617 827**

(73) Patentinhaber: **Siemens Aktiengesellschaft, Berlin und München Wittelsbacherplatz 2, D-8000 München 2 (DE)**

(72) Erfinder: **Pohl, Günter, Ing. grad., Haydnstrasse 8, D-8033 Krailling (DE)**
Erfinder: **Mündel, Gerald, Dipl.-Ing., Pienzenauerstrasse 14, D-8019 Glonn (DE)**

**Beschreibung**

Die vorliegende Erfindung betrifft eine integrierbare Schaltung zur Verhinderung des Sättigungszustands eines Transistors, insbesondere eines Leistungstransistors.

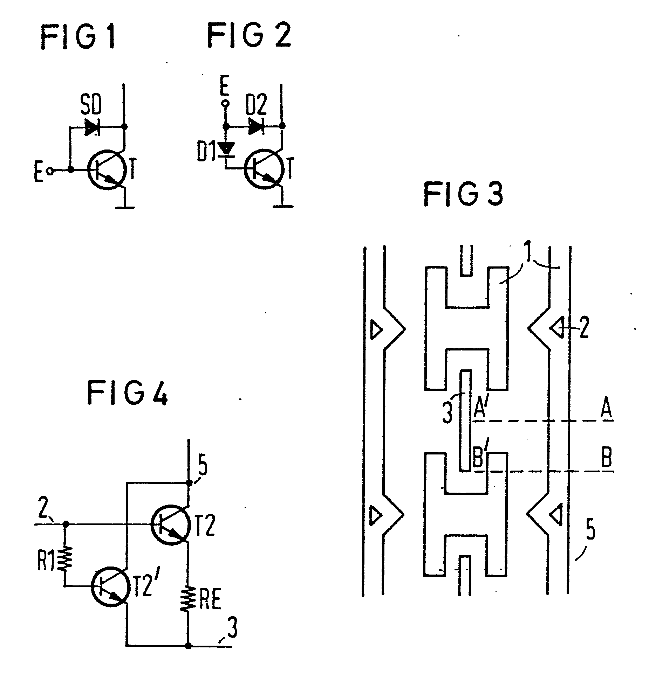

Schaltungen zur Verhinderung der Sättigung sind vor allem bei bipolaren Logikschaltungen bekannt. Ein erstes Beispiel ist in Fig. 1 und ein weiteres Beispiel in Fig. 2 gezeigt. Die Schaltung kann aber auch Transistoren enthalten, wie der weiter unten behandelte Stand der Technik zeigt.

Es erscheint zunächst zweckmässig, auf das Problem der Sättigungsverhinderung bei Transistorschaltungen näher einzugehen.

Hierzu ist zunächst festzustellen, dass bei einem übersteuerten Transistor, d. h. im Falle der Sättigung, die Kollektor-Basis-Diode des übersteuerten Transistors in Flussrichtung kommt und sich deshalb dort eine Diffusionskapazität aufbaut. Wird nun der Transistor in den Sperrzustand umgeschaltet, so muss hierbei diese Diffusionskapazität entladen werden. Dies bedeutet einen Zeitverlust, der mitunter, z. B. bei Niederfrequenz-Leistungsverstärkern, sehr stört. Bei solchen Verstärkern führt z. B. der Eintritt in den Sättigungszustand zu einem unerwünschten Anstieg des Klirrfaktors bei höheren Frequenzen. Diese Problematik tritt auch in den Endtransistoren von Leistungsverstärkern auf. Die dort fliessenden Ströme steigen häufig bis zu mehreren Ampères an und verlangen ausserdem eine gleichmässige Verteilung in den einzelnen Bereichen eines solchen Leistungstransistors, was eine Gleichverteilung der Leistung bedeutet. Leistungstransistoren, die aus mehreren parallelgeschalteten Einzeltransistoren aufgebaut sind, sind z. B. in der DE-OS 2 625 989 beschrieben. Eine Unterdrückung der Sättigung von Transistoren ist aber auch bei gewissen Logikschaltungen erwünscht.

Eine bekannte Methode zur Verhinderung der Sättigung eines Transistors besteht darin, dass man entsprechend Fig. 1 die Anode einer Schottkydiode SD mit der Basis des zu schützenden Transistors T verbindet, während die Kathode der Schottkydiode am Kollektor des, z. B. in Emitterschaltung betriebenen Transistors liegt.

Eine andere bekannte Möglichkeit ist in Fig. 2 dargestellt. Sie sieht ein einerseits durch den Basisanschluss und andererseits durch den Kollektoranschluss des zu schützenden Transistors T beaufschlagtes Netzwerk aus Dioden D1, D2 vor, welches – ebenso wie die Schottkydiode in Fig. 1 – die Aufgabe hat, bei Gefahr einer störenden Absättigung des Transistors T den die Übersteuerung bewirkenden Strom von dem Transistor T vor dem Eintritt der Sättigung wegzunehmen. Auf diese Weise lässt sich z. B. bei einem npn-Transistor die Spannung des durchgeschalteten Transistors auf etwa 0,7 V begrenzen. Dies geschieht beispielsweise mit der in Fig. 2 dargestellten Schaltung, bei der bei einem in Emitterschaltung betriebenen npn-Transistor T die Kollektor-Basisstrecke durch zwei einander gleiche Dioden D1 und D2 überbrückt ist, wobei die Anoden der beiden Dioden D1 und D2 an einem das Potential für den Basisanschluss liefernden Schaltungspunkt E liegen und die Kathode der Diode D2 am Kollektor des Transistors T und die Kathode der Diode D1 an der Basis des Transistors T liegt.

Nachteilig für die Verwendung der bekannten Möglichkeiten zur Sättigungsbehinderung ist, dass sie entweder einen grossen Aussteuerungsstrom brauchen (Fig. 1) oder die Ausgangsspannung des eingeschalteten Transistors in unerwünschter Weise erhöhen. Andererseits ist auch erwünscht, dass sich die Schaltung auch für die Anwendung bei Leistungstransistoren eignet, die durch eine Anzahl parallelgeschalteter integrierter Transistoren gegeben sind, und bei der die Sättigungsunterdrückung bei jedem der den Leistungstransistor aufbauenden Teiltransistoren wirksam sein soll. Da dann für jeden Teiltransistor eine solche Sättigungsunterdrückungsschaltung notwendig ist, sollte sich die Schaltung dann mit möglichst geringem Aufwand und Platzbedarf realisieren lassen. Für Leistungstransistoren, wie man sie vor allem in Verstärkern benötigt, sollte die Sättigung im Interesse der Verminderung des Klirrfaktors (vor allem bei Tonfrequenzen) sowie im Interesse der Unterdrückung einer parasitären Tiefpasswirkung bzw. Phasendrehung und parasitärer Schwingungen möglichst vermieden werden.

Es ist nun Aufgabe der Erfindung, eine Schaltung für die Unterdrückung der Sättigung eines Transistors anzugeben, die sich vor allem für Leistungstransistoren eignet, und die den genannten Gesichtspunkten in vollem Masse gerecht wird.

Gemäss der Erfindung ist eine der eingangs gegebenen Definition entsprechende Schaltung derart ausgestaltet, dass der Kollektor des gegen den Eintritt der Sättigung zu schützenden Transistors über einen Widerstand mit der Basis eines komplementären Transistors sowie mit dem Kollektor eines den gleichen Leitungstyp wie der zu schützende Transistor aufweisenden weiteren Transistors verbunden ist, dass dabei die Basisanschlüsse der beiden den gleichen Leitungstyp aufweisenden Transistoren durch zwei hintereinander geschaltete Widerstände miteinander verbunden und der Teilerpunkt zwischen den beiden Widerständen an den Emitter des komplementären Transistors gelegt ist und dass schliesslich der Emitter des zu schützenden Transistors über einen Widerstand mit dem am Bezugspotential liegenden Kollektor des komplementären Transistors und dem Emitter des denselben Leitungstyp wie der zu schützende Transistor aufweisenden Transistors verbunden ist.

Dabei ist es vorteilhaft, wenn die beiden denselben Leitungstyp aufweisenden Transistoren vom npn-Typ sind und auch in ihren sonstigen Eigenschaften übereinstimmen.

Aufgrund der Erfindung lassen sich Leistungstransistoren aufbauen, die aus einer beliebigen Anzahl parallelgeschalteter Einzeltransistoren bestehen, die ihrerseits in der obenangegebenen Weise gegen den Eintritt der Sättigung individuell geschützt sind. Dies bedeutet, dass jeder Einzeltransistor mit je einer solchen Schutzschaltung ausgerüstet ist. Andererseits sind die oben angestrebten Eigenschaften, u. a. auch der geringe Platzbedarf in vollem Masse erreichbar, ohne dass die Gleichverteilung der Leistung in dem von der Leistungstransistorkonfiguration eingenommenen Platz im Halbleiterchip in irgendeiner Weise nachteilig beeinflusst wird.

Als besonders günstige Lösung wird gemäss der weiteren Erfindung vorgeschlagen, dass die beiden einander gleichen und je einen einzelnen Leistungstransistor darstellenden Transistoren in einer epitaktischen Schicht aus Silicium vom Leitungstyp der Kollektorzone der beiden Leistungstransistoren erzeugt sind und hierzu vorher das zu verwendende Substrat mit einer eine – insbesondere rautenförmige – Lücke aufweisenden buried-layer-Zone versehen wurde, dass ausserdem der erste Leistungstransistor derart in bezug auf die Lücke in der buried-layer-Zone angeordnet ist, dass aufgrund des Vorhandenseins des ersten Leistungstransistors bereits die Existenz des komplementären Transistors sowie des zwischen dem Kollektor des ersten Leistungstransistors und der Basis des komplementären Transistors liegenden Widerstands gegeben ist, und dass schliesslich die Emitterzone des ersten Leistungstransistors in der Nachbarschaft der Emitterelektrode und der die Existenz des komplementären Transistors bedingenden Lücke in der buried-layer-Zone derart gegenüber der Basiszone abgegrenzt ist, dass bereits hierdurch die Existenz des zweiten Leistungstransistors als parasitärer Transistor einschliesslich der übrigen in der Schaltung vorzusehenden Widerstände und deren Zuordnung zu den einzelnen Transistoren gewährleistet ist.

Als Stand der Technik kann hier z. B. die FR-A-2 297 522, die GB-A-2 008 317, die US-A-3 617 827 und die schweizerische CH-A-455 878 genannt werden, in denen integrierte Schaltungen mit Transistoren beschrieben sind, die z. B. in einer n-dotierten epitaktischen Siliciumschicht erzeugt sind, die ihrerseits auf der Oberfläche eines z. B. p-leitendem monokristallinen Siliciumplättchens abgeschieden wurde. Dabei ist am Ort der einzelnen Transistoren an der Grenze zwischen Substrat und Epischicht eine z. B. $n^+$-dotierte buried-layer-Zone vorgesehen, welche sich bevorzugt in einen in der epitaktischen Schicht zu deren Oberfläche erstreckenden $n^+$-dotierten Kanal fortsetzt, der z. B. der Kontaktierung des Kollektors des Transistors dient. Bei den bekannten Schaltungen handelt es sich um Strukturen für eine rasche und daher ungesättigte Logik, die für Leistungstransistoren, insbesondere wegen Störung der Leistungsgleichverteilung, wenig geeignet wäre. Eine Struktur für einen Leistungstransistor findet man in bereits erwähnten DE-OS 2 625 989, auf die anhand der Beschreibung der Fig. 3 eingegangen wird.

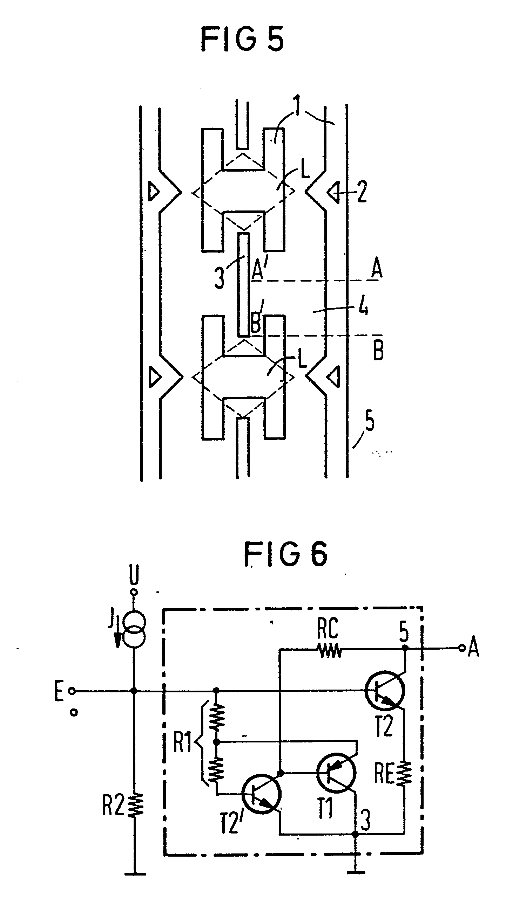

Im folgenden wird die Ausführung der Erfindung anhand eines npn-Leistungstransistors im Vergleich zum Stand der Technik vorgestellt. Dabei ist das Layout in monolithisch integrierter Schaltungstechnik – von oben her gesehen – im bekannten Fall durch Fig. 3 und im Falle der Erfindung durch Fig. 5 dargestellt. Fig. 4 zeigt das zu Fig. 3 und Fig. 6 das zu Fig. 5 gehörende Ersatzschaltbild. Letzteres stellt die der Erfindung entsprechende Schaltung dar.

Der mit «1» bezeichnete Bereich an der Oberfläche eines monokristallinen Siliciumplättchens vom einen Leitungstyp (bzw. einer epitaktischen Schicht vom einen Leitungstyp) ist durch die Basis-Diffusion umdotiert. «2» ist der Basiskontakt. Der Emitter «4» ist über den Kontakt «3» angeschlossen. Das Kollektorgebiet «5» ist ganzflächig mit einem Buried-Layer unterlegt. Längs der Linie A-A' der in Fig. 3 gezeigten Struktur wirkt der eigentliche Leistungstransistor $T_2$ und längs der Linie B-B' der parasitäre Transistor $T'_2$. Der zu schützende Transistor $T_2$ hat in bekannter Weise einen Emitterwiderstand $R_E$ zur Gegenkopplung und führt wegen der grösseren Basis-Emitterfläche beispielsweise den achtfachen Strom zum Strom des parasitären Transistors $T'_2$. Der parasitäre Transistor $T'_2$ wirkt im Sinne einer Gleichverteilung der Ströme in einem Leistungstransistor, der aus mehreren Zellen der in Fig. 3 bzw. 4 gezeigten Ausgestaltung zusammengesetzt ist. Durch das Layout ist ein Basisvorwiderstand «$R_1$» bedingt.

Ein typisches Beispiel für die anhand von Fig. 3 und Fig. 4 dargestellte übliche Struktur eines Leistungstransistors zeigt folgende Werte: $R_E$ = 3 Ohm, $R_1$ = 3 Kiloohm. Der Kollektorstrom des den Verstärker bildenden eigentlichen Leistungstransistors $T_2$, also der Strom $J_{C2}$ beträgt 64 Milliampère, während der Kollektorstrom des parasitären Transistors $T'_2$, also der Strom $J'_{C2}$, sich etwa auf 8 Milliampère beläuft. Der Basisstrom des Transistors $T_2$, also der Strom $J_{B2}$ liegt bei 0,4 Milliampère der Basisstrom des parasitären Transistors $T'_2$ bei 50 Mikroampère.

Wie man aus dem Ersatzschaltbild gemäss Fig. 4 zu der an Hand des Layouts gemäss Fig. 3 ersichtlichen Ausgestaltung von Leistungstransistoren erkennt, ist von der Anwesenheit von Massnahmen, welche dazu geeignet wären, die Sättigung des Transistors T2 zu unterdrücken, nichts zu erkennen.

Für die Erfindung ist es nun von wesentlichem Vorteil, dass sie den parasitären Transistor $T'_2$ und den Widerstand $R_1$ nutzbringend verwendet. Dies wird nun anhand der Fig. 5 und 6 gezeigt, wobei Fig. 5 das Layout und Fig. 6 den entsprechenden Schaltungsplan darstellt.

Im Gegensatz zu der Ausgestaltung gemäss Fig. 3 ist bei dem die Erfindung realisierenden Layout gemäss Fig. 5 das Kollektorgebiet nicht voll von einem buried-Layer unterlegt, sondern der buried-Layer ist an rautenförmigen Lücken «L» ausgespart. Diese Lücken L befinden sich beiderseits der Emitterelektrode 3 unterhalb der beiden H-förmigen Aussparungen 1 der Emitterzone, die auch bei der bekannten Struktur gemäss Fig. 3 vorgesehen sind. In diesen H-förmigen Aussparungen 1 der Emitterzone erreicht die Basis-Dotierung die Siliciumoberfläche. Die Wirkung der Lücken L im buried-Layer in der von der Erfindung vorgesehenen Ausgestaltung besteht in der Erzeugung eines Substrattransistors $T_1$ am Ort der Lücke L und der Entstehung eines Kollektor-Bahnwiderstands $R_C$ für den parasitären Transistor $T'_2$. Die einzelnen Fertigungsschritte bestehen darin, dass auf einem Substrat des einen Leitungstyps eine einkristalline Siliciumschicht vom entgegengesetzten Leitungstyp epitaktisch abgeschieden und zum Transistor $T_2$ weiter verarbeitet wird. Der buried-Layer wird in bekannter Weise an der Substratoberfläche vor deren epitaktischer Beschichtung erzeugt. Emitter und Basis werden in üblicher Weise durch lokalisierte Diffusion und/oder Implantation hergestellt.

Diese Fertigungsschritte sind üblicher Natur und bedürfen keiner weiteren Einzelheiten. Wie die bereits genannte CH-PS 455 878 zeigt, ist auch die Anwendung von buried-Layer mit Unterbrechungen zwecks Erzielung eines komplementären Substrattransistors bei logischen Schaltungen Stand der Technik. Es kommt jedoch bei der Erfindung nicht nur auf die Anwendung eines mit einer Lücke versehenen buried-Layers, sondern auch auf dessen Formgestaltung und Anordnung in bezug auf den Emitter des Leistungstransistors an, die so zu wählen ist, dass eine Schaltungsstruktur gemäss Fig. 6 mit Schutzschaltwirkung zustande kommt.

Der durch die rautenförmige Lücke L im buried-Layer bedingte Substrattransistor $T_1$ hat im vorliegenden Fall die Aufgabe, den den Verstärker bildenden Leistungstransistor $T_2$ gegen die unerwünschte Übersättigung zu schützen. Dabei soll weder die Gleichverteilung der Leistung gestört sein, noch soll ein zusätzlicher Platzbedarf durch die resultierende Schutzschaltung erforderlich sein. Ausserdem soll keine wesentliche Erhöhung der Spannung am Ausgang A, d. h. am Kollektor des zu schützenden Transistors $T_2$, gegen Masse bei durchgeschaltetem Transistor $T_2$ gegeben sein. Alle diese Aufgaben lassen sich, wie gemäss der Erfindung erkannt wurde, lediglich durch die Anwendung einer in geeigneter Weise ausgestalteten und bemessenen Lücke im buried-Layer unterhalb des Transistors T erreichen.

Aufgrund des in Fig. 5 dargestellten Layouts ergibt sich das in Fig. 6 dargestellte Schaltbild, wobei die dem Layout gemäss Fig. 5 angehörenden Teile in Fig. 6 gestrichelt umrandet sind. In diesem Beispielsfall ist das Substrat p-dotiert, der buried-Layer $n^+$-dotiert, der Kollektor von $T_2$ und damit die epitaktische Schicht n-dotiert, die Basis p-dotiert und der Emitter von $T_2$ $n^+$-dotiert.

Der in der epitaktischen Schicht erzeugte und den angestrebten Verstärker bildende npn-Transistor $T_2$ ist infolge der in Fig. 5 gezeigten Ausführung mit seinem Emitter über den Emitterwiderstand $R_E$ an einen Knoten 3 – der Emitterelektrode – gelegt, an dem auch der Emitter eines durch das Layout bedingten parasitären Transistors $T'_2$ – ebenfalls vom npn-Typ – liegt. Der Kollektor des den Verstärker bildenden npn-Transistors $T_2$ liegt an der Kollektorelektrode 5, die zugleich den Ausgang des Verstärkers bildet und über einen durch den Weg innerhalb der Kollektorzone von $T_2$ bedingten Widerstand $R_C$ am Kollektor des parasitären npn-Transistors $T'_2$ liegt, während sein Emitter über den Widerstand $R_E$ mit der Emitterelektrode 3 (an der zwangsläufig auch der Emitter des parasitären npn-Transistors $T'_2$ liegt) verbunden ist.

Der komplementäre Schutztransistor $T_1$ liegt mit seiner Basis am Kollektor des parasitären npn-Transistors $T'_2$, mit seinem Kollektor an der Emitterelektrode 3 des npn-Transistors $T_2$ und damit auch am Emitter des parasitären npn-Transistors $T'_2$. Sein Emitter ist mit dem Teilerpunkt eines Spannungsteilers verbunden, dessen eines Ende an der Basis des zu schützenden npn-Transistors $T_2$ liegt und dessen zweites Ende an der Basis des parasitären Transistors $T'_2$ liegt. Der Spannungsteiler ist mit «$R_1$» bezeichnet.

Als externer Schaltungsteil ist der Widerstand $R_2$, die Stromquelle J und die Versorgungsanschlüsse sowie die Signalanschlüsse E und A, also der Signaleingang und der Signalausgang vorgesehen. Der eine Versorgungsanschluss liefert das Bezugspotential, das sowohl an der Emitterelektrode 3 als auch an dem nicht mit der Basis des zu schützenden npn-Transistors $T_2$ verbundene Ende des externen Widerstands $R_2$ liegt. Das andere Betriebspotential U wird über die z. B. durch eine entsprechende Transistorschaltung gegebene Stromquelle wirksam gemacht.

Solange die Kollektor-Emitterspannung des zu schützenden Transistors $T_2$ (und damit des parasitären Transistors $T'_2$) noch über der Sättigungsspannung liegt, bleibt der komplementäre Schutztransistor $T_1$ gesperrt. Bei zunehmender Sättigungstendenz sinkt insbesondere wegen des Vorhandenseins des Widerstandes $R_C$ die Kollektor-Emitter-Spannung des parasitären Transistors $T'_2$ stärker als die Kollektor-Emitter-Spannung des zu schützenden Transistors $T_2$ ab. Dadurch wird der Schutztransistor $T_1$ leitend und führt den überflüssigen Aussteuerstrom von der Basis 2 gegen das Substrat ab. Somit wird die Sättigung des zu schützenden Transistors $T_2$ verhindert und der parasitäre Transistor $T'_2$ kommt nur in den Zustand der Teilsättigung.

Nun wird man bei der monolithischen Ausführung eines Leistungstransistors $T_2$ diesen in mehreren Teiltransistoren darstellen, was bereits aus den Fig. 3 und 5 hervorgeht. Diese Transistoren sind dann zueinander parallel geschaltet und liegen mit ihren Basisanschlüssen intern oder auch extern an einem gemeinsamen Basisanschluss sowie mit ihren Emittern an einem gemeinsamen zweiten Anschluss als auch mit ihren Kollektoren an einem gemeinsamen dritten Anschluss. Eine ungleichmässige Leistungsverteilung in einem Arbeitspunkt kurz vor der Sättigung wird bei einer Ausgestaltung gemäss der Erfindung erschwert, da dann an Stellen grösserer Leistungsdichte die damit verbundene Temperaturerhöhung des Widerstandes $R_C$ erhöht und dort lokal der Auswertestrom für den den Verstärker darstellenden Transistor $T_2$ und dort lokal der Aussteuerstrom für den komplementären Schutztransistor $T_1$ zuerst erniedrigt wird.

Zusammenfassend kann man für eine Ausgestaltung der Erfindung gemäss Fig. 6 und 5 folgendes feststellen. Als Vorteil ist hier zunächst die Verhinderung der Sättigung des Transistors $T_2$ ohne zusätzlichen Schaltungsaufwand, ohne zusätzlichen Strombedarf, ohne zusätzlichen Platzbedarf und ohne zusätzlichen technologischen Aufwand (wenn man von der besonderen Ausgestaltung der der Erzeugung der Lücken L in der buried-Layer-Zonen erforderlichen Dotierungsmaske absieht) zu verzeichnen. Weiterhin erhält man eine gleichmässigere Leistungsverteilung beim durchgeschalteten Transistor $T_2$.

Experimentell wurden folgende Vergleichwerte zwischen einem in üblicher Weise ausgebildeten Verstärkertransistor und einem durch eine Schutzschaltung gemäss der Erfindung verbesserten und im übrigen sonst gleichen Verstärkertransistor festgestellt und damit der Wert der Erfindung bestätigt:

| Transistor | Restspannung | Ausschaltverzögerung |
|---|---|---|
| Stand der Technik | 600 mV | 520 ns |
| Erfindung | 670 mV | 140 ns |

wobei der Kollektorstrom auf 1 Ampère und die Stromverstärkung B auf 50 eingestellt ist. Bei Abwandlungen der Bedingungen bleiben die gemäss der Erfindung zu erreichenden Vorteile auf jeden Fall gesichert. Ein noch nicht genannter Vorteil ist aus der Tabelle ersichtlich, nämlich die erhöhte Schaltgeschwindigkeit beim Ausschalten des Leistungstransistors. Diese ist fast viermal so gross wie bei einem Transistor ohne die Schutzschaltung gemäss der Erfindung.

Der Vorteil dieser starken Reduzierung der Ausschaltverzögerung beim Leistungstransistor gemäss der Erfindung ist für alle Schaltungen von besonderer Bedeutung, in denen im Leistungstransistor die maximale Geschwindigkeit der Signalverarbeitung beeinflusst. In Leistungstransistoren kommt es nämlich wegen der dort stattfindenden Hochstrominjektion zu einer Ausdehnung der Basisweite und daher zu einem grösseren Speichervolumen in der Basis und als Folge davon zu langen Ausschaltverzögerungen.

**Patentansprüche**

1. Integrierbare Schaltung zur Verhinderung des Sättigungszustandes eines Transistors, insbesondere eines Leistungstransistors, dadurch gekennzeichnet, dass der Kollektor (5) des gegen den Eintritt der Sättigung zu schützenden Transistors ($T_2$) über einen Widerstand (RC) mit der Basis eines komplementären Transistors ($T_1$) sowie mit dem Kollektor eines den gleichen Leitungstyp wie der zu schützende Transistor ($T_2$) aufweisenden weiteren Transistors ($T'_2$) verbunden ist, dass dabei die Basisanschlüsse der beiden den gleichen Leitungstyp aufweisenden Transistoren ($T_2$, $T'_2$) durch zwei hintereinander geschaltete Widerstände ($R_1$) miteinander verbunden sind und der Teilerpunkt zwischen den beiden Widerständen an den Emitter des komplementären Transistors ($T_1$) gelegt ist, und dass schliesslich der Emitter des zu schützenden Transistors ($T_2$) über einen Widerstand (RE) mit dem am Bezugspotential liegenden Kollektor (3) des komplementären Transistors (T1) und dem Emitter des denselben Leitungstyp wie der zu schützende Transistor ($T_2$) aufweisenden Transistors ($T'_2$) verbunden ist.

2. Schaltung nach Anspruch 1, dadurch gekennzeichnet, dass der zu schützende Transistor ($T_2$) vom npn-Typ ist.

3. Schaltung nach Anspruch 1 oder 2, dadurch gekennzeichnet, dass mehrere parallelgeschaltete geschützte Transistoren zu einem Leistungs-Transistor integriert sind.

4. Integrierte Schaltung nach einem der Ansprüche 1 bis 3, dadurch gekennzeichnet, dass der zu schützende Transistor und die Schutzschaltung in einer epitaktischen Schicht aus Silicium vom Leitungstyp der Kollektorzone des zu schützenden Transistors ($T_2$) erzeugt sind, und hierzu vorher das zu verwendende Substrat mit einer eine Lücke (L) aufweisenden buried-layer-Zone versehen wurde, dass ausserdem der zu schützende Transistor ($T_2$) in bezug auf die Lücke (L) in der buried-layer-Zone angeordnet ist, dass aufgrund des Vorhandenseins des zu schützenden Transistors ($T_2$) bereits die Existenz des komplementären Transistors ($T_1$) sowie des zwischen dem Kollektor des zu schützenden Transistors ($T_2$) und der Basis des komplementären Transistors ($T_1$) liegenden Widerstands (RC) gegeben ist, und dass schliesslich die Emitterzone des zu schützenden Transistors in der Nachbarschaft ihrer Emitterelektrode (3) und der die Existenz des komplementären Transistors ($T_1$) bedingenden Lücke (L) in der buried-layer-Zone derart gegenüber der Basiszone abgegrenzt ist, dass bereits hierdurch die Existenz des anderen Transistors ($T'_2$) vom Leitungstyp des zu schützenden Transistors ($T_2$) einschliesslich der übrigen in der Schaltung vorgesehenen Widerstände (RE, R1) und deren Zuordnung zu den Transistoren ($T_2$, $T_1$, $T'_2$) gewährleistet ist.

5. Schaltung nach Anspruch 4, dadurch gekennzeichnet, dass die Lücke in der buried-layer-Zone von rautenförmiger Gestalt und oberhalb der Lücke (L) in der buried-layer-Zone in der Emitterzone (4) eine H-förmige Aussparung in der Emitterzone vorgesehen ist, in der die Basiszone die Oberfläche der epitaktischen Schicht erreicht.

**Claims**

1. An integratable circuit for preventing the condition of saturation of a transistor, in particular a power transistor, characterised in that the collector (5) of the transistor ($T_2$), which is to be protected against the occurrence of saturation, is connected through a resistor (RC) to the base of a complementary transistor ($T_1$) and to the collector of a further transistor ($T'_2$) of the same conductivity type as the transistor ($T_2$) to be protected; that the base terminals of the two transistors ($T_2$, $T'_2$), which have the same conductivity type, are connected to one another through two resistors ($R_1$) connected in series and the divider point between the two resistors is connected to the emitter of the complementary transistor ($T_1$); and that the emitter of the transistor ($T_2$) to be protected is finally connected through a resistor (RE) to the collector (3) of the complementary transistor (T1), which is at the reference potential, and to the emitter of the transistor ($T'_2$) which is of the same conductivity type as the transistor ($T_2$) to be protected.

2. A circuit as claimed in Claim 1, characterised in that the transistor ($T_2$) to be protected is of the npn-type.

3. A circuit as claimed in Claim 1 or Claim 2, characterised in that a plurality of protected transistors, connected in parallel, are integrated to form a power transistor.

4. An integrated circuit as claimed in one of Claims 1 to 3, characterised in that the transistor and the protective circuit are produced in an epitaxial layer consisting of silicon and of the conductivity type of the collector zone of the transistor ($T_2$) to be protected, and for this purpose, the substrate to be used has previously been provided with a buried-layer-zone which has a gap (L); that, moreover, the transistor ($T_2$) to be protected is arranged with reference to the gap (L) in the buried-layer-zone; that by virtue of the presence of the transistor ($T_2$) to be protected, the existence of the complementary transistor ($T_1$) and of the resistor (RC), which is arranged between the collector of the transistor ($T_1$) to be protected and the base of the complementary transistor, is already given; and that finally, the emitter zone of the transistor to be protected in the vicinity of its emitter electrode (3) and the gap (L) in the buried-layer-zone which leads to the existence of the complementary transistor ($T_1$), is delimited from the base zone in such manner that the existence of the other transistor $T'_2$) of the conductivity type of the transistor ($T_2$) to be protected, together with the remaining resistors (RE, R1) which are arranged in the circuit, and their allocation to the transistors ($T_2$, $T_1$, $T'_2$), is already ensured thereby.

5. A circuit as claimed in Claim 4, characterised in that the gap in the buried-layer-zone is diamondshaped and above the gap (L) in the buried-layer-zone in the emitter zone (4), there is arranged an H-shaped recess in the emitter zone, in which the base zone reaches the surface of the epitaxial layer.

**Revendications**

1. Circuit intégrable pour empêcher l'état de saturation d'un transistor, en particulier d'un transistor de puissance, caractérisé par le fait que le collecteur (5) du transistor $T_2$) qui est à protéger contre l'apparition de la saturation est relié, par l'intermédiaire d'une résistance (RC), à la base d'un transistor complémentaire ($T_1$) ainsi qu'au collecteur d'un autre transistor ($T'_2$) de même type de conductibilité que celui du transistor ($T_2$) à protéger, que ce faisant les bornes de base des deux transistors ($T_2$, $T'_2$) ayant le même type de conductibilité sont reliées entre elles par deux résistances ($R_1$) montées l'une derrière l'autre et le point de division entre les deux résistances est relié à l'émetteur du transistor complémentaire ($T_1$), et que finalement l'émetteur du transistor ($T_2$) à protéger est relié par l'intermédiaire d'une résistance (RE) au collecteur (3) du transistor complémentaire ($T_1$), qui est au potentiel de référence, et à l'émetteur du transistor ($T'_2$) qui présente le même type de conductibilité que celui du transistor ($T_2$) à protéger.

2. Circuit selon la revendication 1, caractérisé par le fait que le transistor ($T_2$) à protéger est du type npn.

3. Circuit selon la revendication 1 ou 2, caractérisé par le fait que plusieurs transistors à protéger et montés en parallèle, sont intégrés pour former un transistor de puissance.

4. Circuit intégré selon l'une des revendications 1 à 3, caractérisé par le fait que le transistor à protéger et le circuit de protection sont réalisés dans une couche épitaxiale en silicium du type de conductibilité de la zone de collecteurs du transistor ($T_2$) à protéger et qu'à cet effet le substrat utilisé a été précédemment pourvu d'une zone à couche ensevelie présentant une lacune (L), qu'en outre, le transistor ($T_2$) à protéger est disposé, par rapport à la lacune (L), dans la zone à couche ensevelie, qu'en raison de la présence du transistor ($T_2$) à protéger, l'existence du transistor complémentaire ($T_1$) de même que celle de la résistance (RC) située entre le collecteur du transistor ($T_2$) à protéger et la base du transistor complémentaire ($T_1$), est assurée, et qu'enfin la zone d'émetteur du transistor à protéger est délimitée, dans le voisinage de son électrode d'émetteur (3) et de la lacune (L) dans la zone à couche ensevelie, qui est responsable de l'existence du transistor complémentaire ($T_1$), de telle manière par rapport à la zone de base que cela assure l'existence dudit autre transistor ($T'_2$) de même type de conductibilité que le transistor ($T_2$) à protéger, y compris des autres résistances (RE, R1) prévues dans le circuit et leur association avec les transistors ($T_2$, $T_1$, $T'_2$).

5. Circuit selon la revendication 4, caractérisé par le fait que la lacune dans la zone à couche ensevelie, est rhombiforme et qu'au-dessus de la lacune (L) de la zone à couche ensevelie de la zone d'émetteur (4), il est prévu dans cette dernière une ouverture de la forme d'un H, dans laquelle la zone de base atteint la surface de la couche épitaxiale.

FIG 1

FIG 2

FIG 3

FIG 4

# FIG 5

# FIG 6